# DEMANDE DE BREVET EUROPEEN

(11) **EP 2 159 848 A1**
(43) Date de publication de la demande: **03.03.2010**
(21) Numéro de dépôt: 09167728.6
(22) Date de dépôt: 12.08.2009
(51) Int. Cl.: H01L 31/045

(54) **Composite enroulable photovoltaïque et dispositif de protection solaire comportant un tel composite**

(30) Priorité: 29.08.2008 FR 0855832
(71) Demandeur: Dickson Constant, 59290 Wasquehal (FR)
(72) Inventeur: Nocito, Christophe, 59100, ROUBAIX (FR); Koncar, Vladan, 59320, HAUBOURDIN (FR); Raymond, Laurent, 59134, FOURNES EN WEPPES (FR)
(74) Mandataire: Cochonneau, Olivier

(57) **Abrégé**

La présente invention a pour objet un composite enroulable photovoltaïque, comprenant au moins une cellule photovoltaïque (5,6,7), un panneau textile (12,13,14) et une couche de liaison (15) assurant la liaison entre ladite au moins une cellule photovoltaïque (5,6,7) et ledit panneau textile (12,13,14). De manière caractéristique, la face extérieure (12a,13a,14a) du panneau textile (12,13,14) comprend au moins deux zones conductrices d'électricité (121,122) séparées par une zone non conductrice (125), et la couche de liaison (15) comprend au moins deux zones conductrices d'électricité (151,152) débouchant sur les faces extérieure (15a) et intérieure (15b) de ladite couche de liaison (15) et séparées par une zone non conductrice (153). Les deux zones conductrices (151,152) de la couche de liaison (15) sont disposées entre la cellule photovoltaïque (5,6,7) et la face supérieure (12a,13a,14a) du panneau textile (12,13,14) en sorte que les pôles positif et négatif (8,9) de ladite cellule photovoltaïque (5,6,7) soient en liaison conductrice d'électricité avec les deux zones conductrices (121,122) du panneau textile (12,13,14).

## Description

La présente invention concerne le domaine des composites enroulables photovoltaïques, notamment pour panneau ou store de protection solaire, comprenant au moins une cellule photovoltaïque.

Une cellule photovoltaïque est un générateur appelée aussi photopile qui utilise l'effet photovoltaïque. L'effet photovoltaïque peut être défini comme étant l'apparition d'une différence de potentiel entre deux couches d'une plaquette de semi-conducteur dont les conductivités sont opposées, ou entre un semi-conducteur et un métal, sous l'effet d'un flux lumineux. Une cellule photovoltaïque génère un courant continu.

Un semi-conducteur est généralement un matériau solide dont la résistivité, intermédiaire entre celle des métaux et celle des isolants, varie sous l'influence des facteurs telle que la température, l'éclairement, le champ électrique,...etc.

Les principaux matériaux semi-conducteurs connus sont le germanium, le silicium et le sélénium.

On connaît un chargeur solaire portatif décrit dans WO 2004/077577. Ce chargeur comprend un panneau photovoltaïque souple qui est fixé de façon permanente sur un textile souple. Ledit panneau solaire ou photovoltaïque peut être cousu selon ses bords inactifs à la feuille textile flexible, ou collé, ou encore soudé par apport de chaleur ou d'ultrasons.

La fabrication de ce type de chargeur solaire est encore aujourd'hui artisanale. Il n'existe pas de techniques à ce jour permettant de fabriquer des ensembles, résultant de l'assemblage d'une feuille textile et d'un ou plusieurs panneaux souples photovoltaïques, de grandes dimensions de façon industrielle.

Ces chargeurs de petites dimensions présentent une surface de collecte des rayons incidents faible. De plus, lorsqu'ils sont agencés pour former des panneaux de protection solaire, par exemple pour constituer un store, les coffres de rangement doivent être redimensionnés ne serait ce que pour recevoir la feuille textile à l'état enroulé dont l'épaisseur a très sensiblement augmenté voire doublé une fois assemblée avec un ou plusieurs panneaux photovoltaïques.

On utilise, dans le présent texte, le terme extérieur pour désigner ce qui est destiné à être tourné vers le rayonnement solaire, lors de l'utilisation finale, et bien sûr inversement pour le terme intérieur.

La présente invention pallie les problèmes techniques précités. Elle a pour objet, selon un premier aspect, un composite enroulable photovoltaïque, notamment pour la protection solaire, comprenant au moins une cellule photovoltaïque souple ayant des pôles positif et négatif, un panneau textile délimité par des faces extérieure et intérieure, et une couche de liaison délimitée par une face extérieure et une face intérieure et assurant la liaison entre ladite au moins une cellule photovoltaïque et ledit panneau textile. De manière caractéristique, la face extérieure du panneau textile comprend au moins deux zones conductrices d'électricité séparées par une zone non conductrice, la face intérieure du panneau textile n'étant pas conductrice d'électricité. La couche de liaison comprend au moins deux zones conductrices d'électricité débouchant sur les faces extérieure et intérieure de ladite couche de liaison et séparées par une zone non conductrice. Les deux zones conductrices de la couche de liaison sont disposées entre la cellule photovoltaïque et la face supérieure du panneau textile en sorte que les pôles positif et négatif de ladite cellule photovoltaïque soient en liaison conductrice d'électricité avec les deux zones conductrices du panneau textile.

Ainsi, dans le composite de la présente invention, le panneau textile lui-même peut être utilisé comme l'un des moyens d'acheminement de l'électricité produite par la cellule photovoltaïque vers les moyens de stockage ou les moyens de raccordement au réseau, ce qui évite le raccordement direct des moyens d'acheminement à la cellule photovoltaïque comme c'est le cas dans les chargeurs souples portatifs connus de l'état de la technique.

Le composite enroulable photovoltaïque peut être utilisé dans toutes les applications nécessitant un panneau de protection solaire, et notamment dans les applications suivantes : tentes, auvents, abris, pergolas, stores, tauds de bateau, parasols, capotes de voitures ainsi que pour les vérandas et les couvertures de piscine.

La cellule photovoltaïque est de préférence assemblée avec ledit panneau textile de manière à ce qu'elle soit enroulée dans le sens de la longueur.

Les cellules photovoltaïques préférées sont à base de silicium amorphe et sont aptes à subir un enroulement ayant un rayon de courbure minimum de l'ordre de 25 mm, voire moins, sans se dégrader.

Les pôles positif et négatif correspondent respectivement aux électrodes négative et positive d'une cellule photovoltaïque et sont par exemple formés au moyen d'une bande adhésive dans un matériau conducteur, par exemple du cuivre.

Lorsque le composite est utilisé pour la protection solaire, la face intérieure du panneau textile étant orientée vers l'usager, elle ne doit pas conduire l'électricité pour des raisons de sécurité. De plus, de préférence la face intérieure du panneau textile est revêtue d'un apprêt imperméabilisant aux liquides, notamment à l'eau, le composite protégeant également de la pluie et du vent.

La couche de liaison assure la fonction de solidarisation de la cellule photovoltaïque au panneau textile et, selon la présente invention, la fonction de moyen de raccordement électrique entre ladite cellule photovoltaïque et le panneau textile. La couche de liaison est de préférence thermo-fusible et obtenue par exemple par extrusion-calandrage de bandes ou zones conductrices d'électricité conjointement avec des bandes ou zones non conductrices d'électricité. Les zones conductrices et non conductrices d'électricité peuvent être dans le même matériau polymère ou dans des matériaux polymères différents. De préférence, pour former les zones conductrices, le matériau polymère contient une charge rendant le matériau conducteur, par exemple du noir de carbone.

Le panneau textile peut être choisi parmi les textiles suivants : tissu simple, tissu double face, tricot ou nontissé, ou une combinaison de ces textiles.

Le panneau textile est de préférence thermofixé, notamment soumis à un retrait compressif contrôlé du type sanforisage, afin de l'assouplir et effectuer un retrait contrôlé des fils le constituant et de sa structure. Lorsque le panneau textile est un tissu, les fils de chaîne et de trame sont de préférence identiques afin d'améliorer la stabilité dimensionnelle du tissu lors du laminage à chaud de la couche de liaison réalisant la solidarisation de la cellule photovoltaïque sur la face extérieure du tissu. Avantageusement, le demandeur s'est aperçu que cette thermo fixation évite la formation de plis lors de cette opération de laminage à chaud.

De plus, pour éviter tout transpercement lors de ladite étape de laminage, il est préférable que la face intérieure du panneau textile soit revêtue d'une enduction faisant office de barrière à la couche de liaison ramollie, éventuellement en complément de l'apprêt imperméabilisant aux liquides, notamment à l'eau.

Selon une particularité de l'invention, les moyens d'acheminement vers un dispositif de stockage, telle qu'une batterie, de l'énergie électrique générée par la cellule photovoltaïque sont directement raccordés aux premières zones conductrices du panneau textile.

Dans une variante de réalisation, ladite au moins une cellule photovoltaïque comprend sur sa face extérieure une couche de protection dans un matériau laissant passer les rayons lumineux et non conducteur d'électricité, de préférence résistant à l'abrasion, par exemple polytétrafluoréthylène transparent, ETFE. Dans ce dernier cas, la couche de protection est solidarisée à la cellule photovoltaïque par une seconde couche de liaison, qui de préférence est dans le même matériau que la couche de liaison solidarisant la cellule photovoltaïque et le panneau textile.

Cette couche de protection, éventuellement incluant la seconde couche de liaison, est de préférence appliquée sensiblement selon toute la face extérieure du panneau textile associé avec la couche de liaison et la cellule photovoltaïque, de préférence à l'exception des bords extérieurs du panneau textile. Ceci permet de limiter les différences d'épaisseur du composite sur toute sa surface.

Dans une variante de réalisation, le panneau textile est un tissu double étoffe ou double face et la face extérieure dudit panneau textile comprend des fils conducteurs d'électricité dans les zones conductrices d'électricité.

Un tissu double étoffe ou double face permet d'obtenir des faces endroit et envers, respectivement extérieure et intérieure, présentant des armures différentes et donc des propriétés différentes. Selon l'invention, la face intérieure ne conduit pas l'électricité pour des raisons de sécurité et d'isolation afin d'éviter des pertes d'énergie électrique tandis que les fils conducteurs de la face extérieure conduisent l'électricité selon les zones conductrices localisées et ayant des dimensions déterminées selon l'armure de tissage et les fils sélectionnés lors du tissage. Ainsi l'acheminement de l'énergie électrique produite est intégré dans le panneau textile ce qui permet de diminuer l'encombrement, et notamment l'épaisseur du composite.

Dans une sous-variante de réalisation, les zones conductrices du panneau textile comprennent des flottés de fils conducteurs d'électricité. Cette disposition augmente la superficie active de la zone conductrice et donc limite les pertes de l'énergie électrique produite.

Dans une sous-variante de réalisation, le panneau textile est tissé selon une armure de tissage du type reps ou nattés. Ce type d'armure favorise les flottés.

Dans une variante de réalisation, les zones conductrices du panneau textile comprennent des fils conducteurs d'électricité brodés sur la face extérieure du panneau textile. Le panneau textile est alors déterminé, ainsi que les moyens de broderie, en sorte que l'aiguille effectuant la broderie ne traverse pas de part en part ledit panneau et qu'un fil conducteur ne débouche pas selon sa face intérieure. De préférence, le panneau textile présente une épaisseur importante et/ou est du type tissu double face.

Dans une variante de réalisation, les fils conducteurs d'électricité sont des fils choisi parmi les métaux conducteurs suivants : cuivre, argent ou leurs alliages. La conductivité électrique des fils sélectionnés doit être importante afin de diminuer les pertes de l'énergie électrique.

Dans une variante de réalisation, les zones conductrices du panneau textile comprennent un revêtement conducteur d'électricité.

Le revêtement conducteur d'électricité, de préférence en cuivre, en argent ou dans un alliage de ces métaux, est déposé de préférence par oxydoréduction, et de manière générale par toutes techniques équivalentes connues dans l'état de la technique. Les zones conductrices faisant office d'électrode positive ou négative sont de préférence aptes à recevoir un courant de cinq ampères et une tension de 30 volts afin de générer une puissance de l'ordre de 150 watts.

Dans une sous-variante de réalisation, le panneau textile comprend sur sa face extérieure un liant, notamment non conducteur d'électricité, pour la solidarisation dudit revêtement conducteur.

Dans une variante de réalisation, la couche de liaison est dans un polymère thermofusible, de préférence dans un polymère à base d'EVA (copolymère d'éthylène et d'acétate de vinyle) qui contient une charge conductrice dans les zones conductrices, par exemple du noir de carbone.

Dans une variante de réalisation, le composite photovoltaïque comprend plusieurs panneaux textiles assemblés, chacun ayant selon sa face extérieure un groupe de cellules photovoltaïque montées électriquement en série ou en parallèle, de préférence chaque groupe comporte au moins trois cellules photovoltaïques. Les groupes de cellules photovoltaïques des différents panneaux sont électriquement reliés et montés en série ou en parallèle.

De préférence les panneaux textiles sont assemblés deux à deux avec superposition partielle selon leurs bords longitudinaux. Dans le cas où leur face intérieure comporte une enduction, il est prévu que dans la zone de superposition ladite face intérieure soit exempte d'enduction, celle-ci pouvant être une gêne pour réaliser l'assemblage

La présente invention a pour objet, selon un deuxième aspect, un dispositif de protection solaire, comprenant un composite enroulable photovoltaïque selon la présente invention, dans l'une ou l'autre de ses variantes de réalisation, un tube de réception monté fixe sur un support, éventuellement disposé dans un coffre de rangement, et solidarisé audit composite selon un premier bord de celui-ci, une barre de charge solidarisée audit composite selon un second bord opposé audit premier bord. Le dispositif comprend également des moyens d'acheminement de l'énergie électrique directement raccordés aux zones conductrices du ou desdits panneaux textiles et disposés dans le tube d'enroulement et/ou dans la barre de charge.

Dans une variante de réalisation de ce dispositif, le raccordement des moyens d'acheminement est réalisé au niveau d'au moins une languette de raccordement, découpée dans le premier ou le second bord d'un panneau textile. Dans ce cas, de préférence, la solidarisation du composite au tube de réception ou à la barre de charge se fait en mettant en oeuvre la ou les parties respectivement du premier ou second bord du panneau textile, adjacentes à la languette. Ainsi le même bord du panneau textile permet, par deux simples découpes pour former la languette, de remplir deux fonctions : celle du raccordement aux moyens d'acheminement de l'électricité et celle de fixation sur le tube de réception ou la barre de charge.

La présente invention sera mieux comprise à la lecture d'un exemple de réalisation cité à titre non limitatif, et illustré dans les figures ci-après annexées à la présente et dans lesquelles :
- la figure 1 est une vue de dessus d'un composite photovoltaïque selon la présente invention comprenant trois groupes de cellules photovoltaïques ;
- la figure 2 est une vue selon la plan de coupe II-II réalisé à la figure 1 ;
- la figure 3 est une variante de réalisation du composite représenté à la figure 2 ;

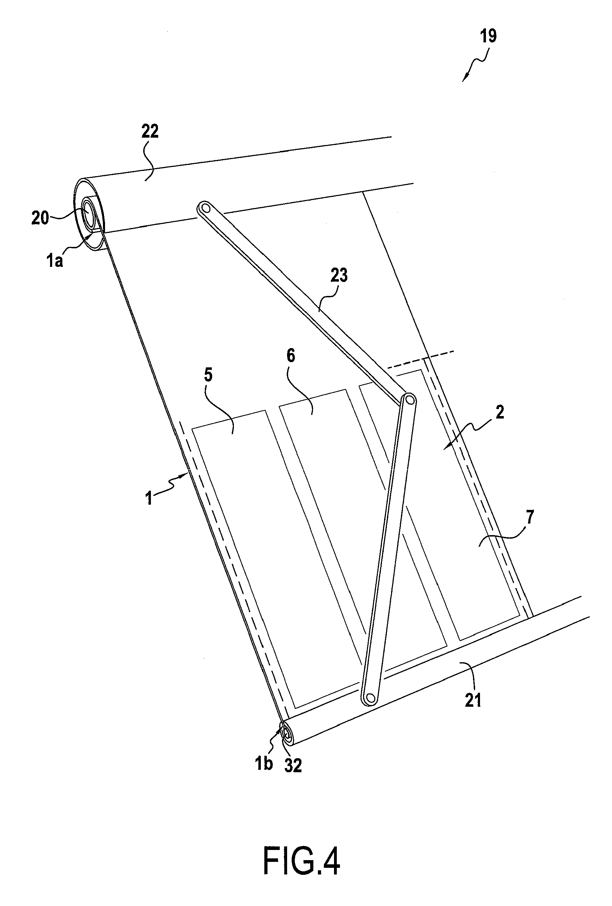

- la figure 4 est une vue en perspective d'un dispositif de protection solaire pour un camping-car comprenant un composite photovoltaïque enroulable selon l'invention.

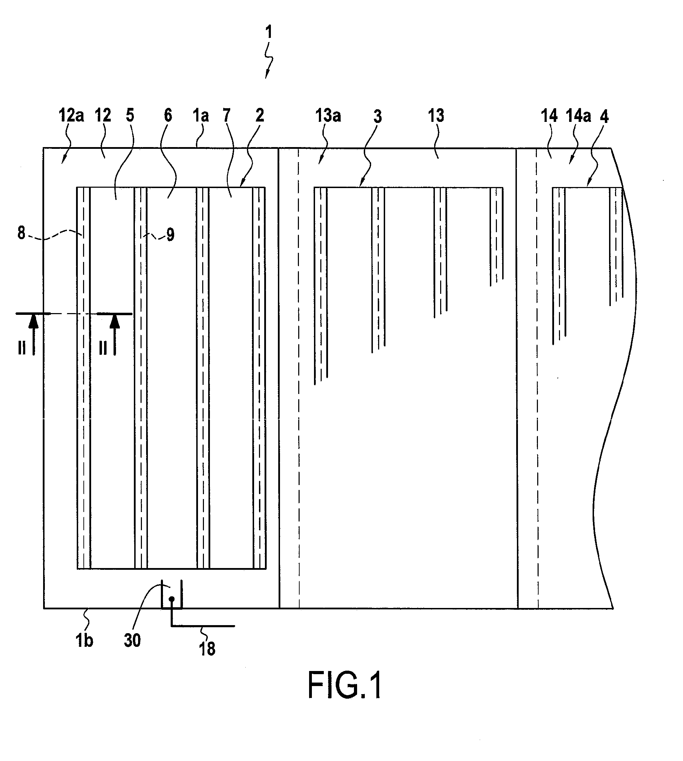

Le composite enroulable photovoltaïque qui va être décrit ci-dessous et qui est représenté à la figure 1 est destiné à former un store de protection solaire pour camping-car. Cette description et cette application ne sont bien sur pas limitatives de la présente invention.

Le composite 1 comprend trois groupes de cellules photovoltaïques 2,3,4 souples, lesquels groupes 2,3,4 sont montés électriquement en parallèle, chaque groupe 2,3,4 comprenant trois cellules photovoltaïques également montées électriquement en parallèle. Pour des raisons de simplification, seules les cellules photovoltaïques 5,6,7 du premier groupe 2 sont représentées, et plus particulièrement la cellule photovoltaïque 5. Chaque cellule photovoltaïque 5 comprend des électrodes positives et négatives 8,9 respectivement formées par des bandes adhésives rapportées sur la face intérieure dudit groupe photovoltaïque 2 ; dans cet exemple précis les bandes sont en cuivre. Chaque cellule se présente sous forme d'un film sur lequel a été déposée une fine couche d'un semi-conducteur, notamment du silicium.

Le composite 1 comprend également trois panneaux textiles 12,13,14 assemblés par collage, selon leurs bords longitudinaux superposés, et délimités par des faces extérieures et intérieures ainsi qu'une couche de liaison 15 délimitée par des faces extérieure et intérieure et assurant la liaison entre les trois groupes de cellules photovoltaïques 2,3,4 et les faces extérieures 12a,13a,14a des panneaux textiles 12,13,14.

La face intérieure de chaque panneau est revêtue d'une enduction et/ou d'un apprêt imperméable aux liquides, notamment à l'eau, à l'exception de la zone latérale dite de réserve, selon le bord longitudinal du panneau 13 qui était au-dessus de l'autre 12 lors de l'assemblage des deux zones superposées 31 desdits panneaux adjacents 12,13. L'absence d'enduction et/ou d'apprêt dans cette zone de réserve évite tout risque de délaminage entre les panneaux assemblés. De plus, l'enduction sur la face intérieure permet d'éviter tout risque de transpercement du panneau textile lors du laminage à chaud de la couche de liaison pour la fixation de la cellule photovoltaïque sur ledit panneau.

De préférence, afin de renforcer l'assemblage des panneaux textiles 12,13 et 14, notamment compte-tenu de la charge exercée par les groupes de cellules photovoltaïques 5,6 et 7, des coutures de renforcement sont pratiquées selon leurs bords adjacents assemblés.

Les faces extérieures 12a,13a,14a des panneaux textiles 12,13,14 comprennent des zones conductrices d'électricité séparées par des zones non conductrices. De même, la couche de liaison 15 comprend autant de zones conductrices d'électricité traversantes, c'est-à-dire débouchant à la fois sur la face extérieure 15a et sur la face intérieure 15b de ladite couche de liaison 15, et séparées par des zones non conductrices. Le nombre de zones conductrices dépend du montage électrique choisi, en parallèle ou en série. Au moins une zone conductrice est disposée au regard d'une électrode 8,9 d'une cellule photovoltaïque 5. Les zones conductrices 151,152 de la couche de liaison 15 sont disposées entre les zones conductrices correspondantes 121,122 du panneau textile 12 et les électrodes positives et négatives 8,9 de la cellule photovoltaïque 5. Ainsi chaque cellule photovoltaïque est en liaison conductrice d'électricité avec un panneau textile.

Les faces intérieures des panneaux textiles 12,13,14 ne sont pas conductrices d'électricité pour des raisons de sécurité puisqu'elles sont orientées directement vers l'usager.

La couche de liaison 15 est dans un polymère thermo-fusible, dans cet exemple précis à base d'un copolymère d'éthylène et d'acétate de vinyle (EVA). Les zones 151,152 sont rendues conductrices par apport d'une charge adéquate, par exemple du noir de carbone.

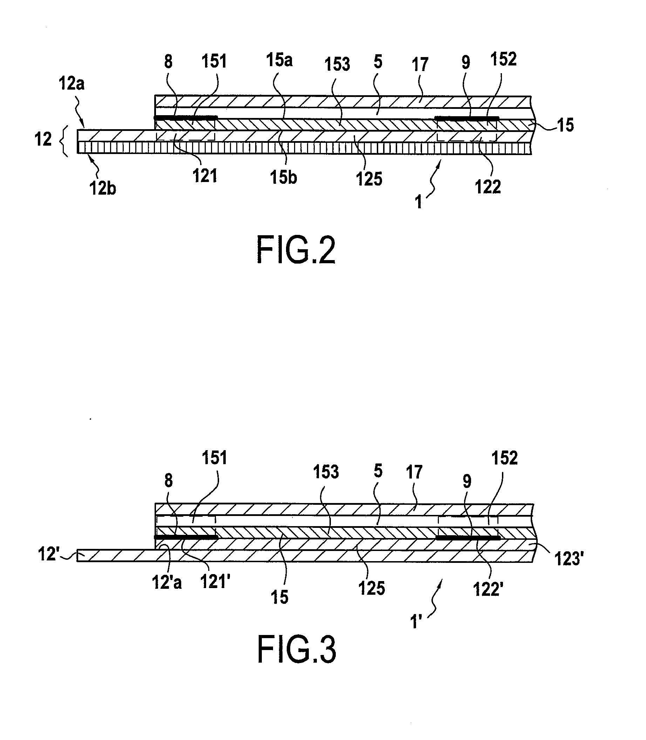

Chaque panneau textile 12 est un tissu double étoffe comportant des faces extérieure 12a et intérieure 12b distinctes tel que représenté à la figure 2. Les zones conductrices 121,122 sont obtenues par des flottés de fils conducteurs d'électricité, de préférence dans des métaux ayant une forte conductivité afin d'éviter toute perte d'énergie électrique.

La figure 3 représente une variante de réalisation du panneau textile 12. Seuls les éléments différents ont été renumérotés. Le panneau textile 12' n'est pas forcément un tissu double face, par exemple une toile simple, mais doit comporter une face intérieure non conductrice. Le panneau 12' comporte sur sa face supérieure plusieurs revêtements de métaux conducteurs localisés 121',122', en sorte de former des zones conductrices disposées au regard des zones conductrices 151,152 de la couche de liaison 15. Un liant 123' non conducteur d'électricité peut être disposé directement selon la face extérieure 12a' du panneau textile 12' en sorte de favoriser l'adhérence des revêtements métallisés conducteurs 121',122'.

Les composites 1 et 1' comprennent également une couche extérieure de protection 17 qui recouvre au moins les groupes de cellules photovoltaïques 2,3,4. Ladite couche de protection 17 est dans un matériau laissant passer les rayons lumineux, non conducteur d'électricité et résistant à l'abrasion. Elle est par exemple dans un polytétrafluoréthylène transparent ETFE. Elle n'est pas elle-même adhérente et sa fixation nécessite la mise en oeuvre d'une seconde couche de liaison, qui peut être dans le même matériau que la couche de liaison 15 utilisée pour fixer chaque cellule photovoltaïque sur un panneau textile, par exemple en EVA. Dans ce cas, de préférence, pour limiter les différences d'épaisseur du composite, les deux couches de liaison et la couche de protection ont des dimensions supérieures à celles des cellules photovoltaïques.

Des moyens d'acheminement 18 de l'énergie électrique produite par le premier groupe photovoltaïque 2 sont directement raccordés à chaque panneau textile 12 selon ses zones conductrices 121,122.

Le composite enroulable photovoltaïque 1 est, en fonctionnement, intégré dans un dispositif de protection solaire 19, en particulier en tant que store de camping-car. Le dispositif 19 comprend un tube de réception 20, monté sur le camping-car et disposé rotatif à l'intérieur d'un coffre de rangement intérieurement cylindrique, et une barre de charge 21. Lorsque le composite photovoltaïque 1 est à l'état enroulé sur lui-même autour du tube de réception 20, la barre de charge 21 maintient le coffre de rangement fermé. Le composite photovoltaïque 1 est solidarisé le long de sa première extrémité la au tube de réception 20 et le long de sa seconde extrémité 1b à la barre de charge 21, à l'opposé dudit tube 20. Les moyens d'acheminement de l'énergie électrique 18 produite par le premier groupe de cellules photovoltaïques 2 sont directement raccordés aux zones conductrices textiles 121,122. Ce raccordement intervient au niveau d'une languette de raccordement 30 qui a été préalablement, lors de la confection du composite, découpée dans un bord transversal 2b du panneau de part et d'autre du prolongement des zones conductrices. Les moyens d'acheminement 18 passent tout d'abord dans un boîtier de protection des connexions non représenté puis dans la barre de charge 21, dans un premier bras 23 de mise en tension, qui dans l'exemple illustré est un bras articulé mais qui peut aussi être télescopique, et enfin dans le coffre de rangement 22 ou le tube de réception 20, pour être enfin raccordé à un moyen de stockage du type batterie. Chaque groupe de cellules photovoltaïques 2,3,4 comprend un boîtier de protection hébergeant une diode anti-retour afin de répondre à la norme CEI 61646.

Le choix du montage électrique en parallèle ou en série des groupes de cellules photovoltaïques 2,3,4 ainsi que des cellules 5,6,7 elles-mêmes dans ces groupes 2 est déterminé principalement en fonction des applications visées. Le montage sera différent s'il s'agit de stocker l'électricité produite sur une batterie ou s'il s'agit d'alimenter directement le réseau électrique existant. De plus il faut veiller à ce que l'énergie électrique produite soit répartie de la façon la plus homogène possible entre les différents groupes de cellules en sorte qu'il n'y ait pas d'échauffement localisé. En effet, un tel échauffement risquerait de dégrader la ou les couches de liaison, voire de les fondre partiellement. Les zones conductrices d'électricité, notamment les zones 121,122,151,152, ne seraient alors plus correctement isolées.

Afin de faciliter le dimensionnement du dispositif 19, les moyens d'acheminement sont intégrés dans le bras 23 ou éventuellement répartis dans deux bras assurant la mise en tension dudit composite 1 lors de son déploiement. Les boîtiers sont de préférence disposés aux extrémités du bras 23 et dans la direction opposée à leur repliement en sorte de ne pas gêner leurs mouvements lors du rangement du composite 1 dans le coffre.

La fixation du composite sur la barre de charge peut intervenir en mettant en oeuvre les parties du panneau textile qui sont adjacentes à la languette de raccordement 30, notamment en les collant sur une tige 32 disposée intérieurement dans la barre de charge 21.

Dans un exemple précis et non exhaustif, la longueur L et la largeur I de chacune des cellules photovoltaïques sont respectivement de l'ordre de 122 cm et de 29,2 cm.

Lorsque le composite 1,1' selon la présente invention est utilisé en tant que store traditionnel, la longueur des groupes de cellules photovoltaïques est par exemple de l'ordre de 244 cm.

Pour des raisons d'isolation et aussi de confection et de fixation sur le tube de réception 20 et la barre de charge 21, les bords extérieurs selon les faces extérieures 12a,13a,14a des panneaux textiles 12,13,14 ne sont pas revêtus de la ou des couches de liaison et de la couche de protection.

## Revendications

1. Composite enroulable photovoltaïque, notamment pour la protection solaire, comprenant au moins une cellule photovoltaïque ayant des pôles positif et négatif, un panneau textile délimité par des faces extérieure et intérieure, et une couche de liaison délimitée par une face extérieure et une face intérieure et assurant la liaison entre ladite au moins une cellule photovoltaïque et ledit panneau textile **caractérisé en ce que :**
a) la face extérieure du panneau textile comprend au moins deux zones conductrices d'électricité séparées par une zone non conductrice,
b) la face intérieure du panneau textile n'est pas conductrice d'électricité,
c) la couche de liaison comprend au moins deux zones conductrices d'électricité débouchant sur les faces extérieure et intérieure de ladite couche de liaison et séparées par une zone non conductrice,
et **en ce que** les deux zones conductrices de la couche de liaison sont disposées entre la cellule photovoltaïque et la face supérieure du panneau textile en sorte que les pôles positif et négatif de ladite cellule photovoltaïque sont en liaison conductrice d'électricité avec les deux zones conductrices du panneau textile.

2. Composite photovoltaïque selon la revendication 1, **caractérisé en ce que** le panneau textile est un tissu double étoffe ou double face, et **en ce que** la face extérieure dudit panneau textile comprend des fils conducteurs d'électricité formant les zones conductrices d'électricité.

3. Composite photovoltaïque selon la revendication 2, **caractérisé en ce que** les fils conducteurs d'électricité forment des flottés.

4. Composite photovoltaïque selon l'une ou l'autre des revendications 2 et 3, **caractérisé en ce que** le panneau textile est tissé selon une armure de tissage du type reps ou nattés.

5. Composite photovoltaïque selon la revendication 1, **caractérisé en ce que** les zones conductrices d'électricité du panneau textile comprennent des fils conducteurs d'électricité brodés sur la face extérieure du panneau textile.

6. Composite photovoltaïque selon l'une des revendications 1 à 5, **caractérisé en ce que** les fils conducteurs d'électricité sont des fils choisi parmi les métaux conducteurs suivants : cuivre, argent ou leurs alliages.

7. Composite photovoltaïque selon l'une des revendications 1 à 3, **caractérisé en ce que** les zones conductrices d'électricité du panneau textile comprennent un revêtement conducteur d'électricité fixé sur la face extérieure dudit panneau, éventuellement à l'aide d'un liant non conducteur d'électricité.

8. Composite photovoltaïque selon l'une des revendications 1 à 7, **caractérisé en ce que** la couche de liaison est dans un polymère thermo fusible, de préférence dans un polymère à base d'EVA (copolymère d'éthylène et d'acétate de vinyle), et **en ce que** les zones conductrices de ladite couche de liaison comportent une charge lui conférant des propriétés conductrices d'électricité, notamment du noir de carbone.

9. Composite photovoltaïque selon l'une des revendications 1 à 8, **caractérisé en ce qu'**il comporte une couche de protection extérieure recouvrant au moins la cellule photovoltaïque, dans un matériau laissant passer les rayons lumineux et non conducteur d'électricité, par exemple en ETFE, ladite couche de protection étant fixée par une seconde couche de liaison.

10. Composite photovoltaïque selon l'une des revendications 1 à 9, **caractérisé en ce qu'**il comprend plusieurs panneaux textiles assemblés ayant chacun selon leurs faces extérieures un groupe de plusieurs cellules photovoltaïques, de préférence au moins trois cellules, qui sont montées électriquement en série ou en parallèle, les groupes étant eux-mêmes montés électriquement en série ou en parallèle.

11. Composite photovoltaïque selon l'une des revendications 9 ou 10, **caractérisé en ce** les couches de liaison et la couche de protection ont des dimensions supérieures à celles de la ou des cellules photovoltaïques.

12. Composite photovoltaïque selon l'une des revendications 1 à 11, **caractérisé en ce qu'**il comporte au moins une languette de raccordement formée par découpe dans un bord du panneau textile de part et d'autre d'au moins une zone conductrice.

13. Dispositif de protection solaire, comprenant un composite enroulable photovoltaïque selon l'une des revendications 1 à 12, un tube de réception monté sur un support, éventuellement disposé dans un coffre de rangement, et solidarisé audit composite selon un premier bord, une barre de charge solidarisée audit composite selon un second bord opposé audit premier bord, **caractérisé en ce qu'**il comprend des moyens d'acheminement de l'énergie électrique directement raccordés aux zones conductrices du ou desdits panneaux textiles et disposés dans le tube d'enroulement et/ou dans la barre de charge.

14. Dispositif selon la revendication 13, comprenant un composite selon la revendication 12, **caractérisé en ce que** le raccordement aux moyens d'acheminement intervient au niveau de la languette de raccordement et **en ce que** la fixation du composite sur le tube de réception ou la barre de charge intervient au niveau des parties du panneau textile adjacentes à la languette de raccordement.
